(19) Europäisches Patentamt
European Patent Office
Office européen des brevets

(11) **EP 2 475 017 A2**

(12) **EUROPEAN PATENT APPLICATION**

(43) Date of publication:
**11.07.2012 Bulletin 2012/28**

(51) Int Cl.:
**H01L 33/58** (2010.01)

(21) Application number: **11180841.6**

(22) Date of filing: **12.09.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **05.01.2011 KR 20110000985**

(71) Applicant: **Samsung LED Co., Ltd. Gyunggi-do (KR)**

(72) Inventors:
• **Park, Cheon Ho Gyunggi-do (KR)**
• **You, Jae Sung Gyunggi-do (KR)**

(74) Representative: **Grünecker, Kinkeldey, Stockmair & Schwanhäusser Leopoldstrasse 4 80802 München (DE)**

(54) **LED Package with a lens**

(57) A light emitting device (LED) package is disclosed. The light emitting device package includes a light emitting device (10), a substrate (20) on which the light emitting device is mounted; and a lens (30) mounted on the substrate so as to cover and seal the light emitting device and having an accommodating groove formed in a lower surface thereof contacting the substrate, the accommodating groove (31) accommodating the light emitting device, and a concave portion (32) formed in an upper surface thereof in such a manner as to be disposed at a position corresponding to the light emitting device, wherein the concave portion has a radius of curvature on an optical axis of the lens and is formed to be depressed from the upper surface to the lower surface.

FIG. 2

**Description**

**CROSS-REFERENCE TO RELATED APPLICATION**

This application claims the priority of Korean Patent Application No. 10-2011-0000985 filed on January 5, 2011, in the Korean Intellectual Property Office, the disclosure of which is incorporated herein by reference.

**BACKGROUND OF THE INVENTION**

**Field of the Invention**

The present invention relates to a light emitting device package.

**Description of the Related Art**

In general, a liquid crystal display (LCD), currently a common thin display device has been applied to various devices, such as a wall-mounted type television, a notebook computer, a monitor for a desktop computer, a navigation system, a personal digital assistant (PDA), a cellular phone, and a portable computer game console or the like. A liquid crystal constituting the display device of the liquid crystal display may not emit light by itself, and may merely perform a function of simply transmitting or blocking light according to an electrical signal applied thereto.

Accordingly, in order to display information on a liquid crystal panel, a so-called surface light emitting device for irradiating the liquid crystal panel from the rear, a backlight unit needs to be separately provided in a liquid crystal display. Such a backlight unit may need to increase the luminance of light and form an even surface light source to irradiate a liquid crystal panel, which is very important in an aspect of product quality.

Since a general backlight unit has a small size and a long lifespan and directly converts electrical energy to optical energy, a light emitting device (LED) having advantages such as, high energy efficiency and a low level of operating voltage has been used as a light source for the backlight unit.

In the case of a direct type backlight unit directly irradiating a liquid crystal panel from a surface light source disposed below the liquid crystal panel, since the distribution of light emitted from a light emitting device is in the form of Lambertian distribution, an orientation angle may be on the level of approximately 120 degrees, and since the liquid crystal panel is distant from the light source, a bright screen having good luminance uniformity may only be obtained in the case of using a plurality of light emitting devices.

**SUMMARY OF THE INVENTION**

An aspect of the present invention provides a light emitting device package in which the light distribution of emitted light is widened to thereby reduce the thickness of a product, as well as to reduce the required amount of light emitting devices.

According to an aspect of the present invention, there is provided a light emitting device package, including: a light emitting device; a substrate on which the light emitting device is mounted in plural; and a lens mounted on the substrate so as to cover and seal the light emitting device and having an accommodating groove formed in a lower surface thereof contacting the substrate, the accommodating groove accommodating the light emitting device, and a concave portion formed in an upper surface thereof in such a manner as to be disposed at a position corresponding to the light emitting device, wherein the concave portion has a radius of curvature on an optical axis of the lens and is formed to be depressed from the upper surface to the lower surface.

The light emitting device package may further include a phosphor layer filling the accommodating groove and surrounding the light emitting device.

In the lens, the upper surface may be formed to have a curved surface, a cross-section of which having parabolic shapes respectively based on the concave portion, and the curved surface having the parabolic shape may be formed at a location higher than that of the accommodating groove

The lens may satisfy the following conditional expression 1,

$$[\text{Conditional Expression 1}]$$

$$0.4 \ < \ Tc/Tt < 0.85$$

where, Tc is a distance from the low surface of the lens to the upper surface thereof on the optical axis; and Tt is a distance from the lower surface of the lens to the highest upper surface thereof.

The lens may satisfy the following conditional expression 2,

$$[Conditional\ Expression\ 2]$$

$$0.3 < Rt/Rmax < 0.75$$

where, Rt is a distance from the optical axis to the highest upper surface of the lens; and Rmax is a distance from the optical axis to an exterior surface of the lens.

The lens may satisfy the following conditional expression 3,

$$[Conditional\ Expression\ 3]\ 0.1 < Rc$$

where, Rc is the radius of curvature of the concave portion formed in the upper surface of the lens, on the optical axis.

## BRIEF DESCRIPTION OF THE DRAWINGS

The above and other aspects, features and other advantages of the present invention will be more clearly understood from the following detailed description taken in conjunction with the accompanying drawings, in which:

FIG. 1 is a diagram schematically showing a light emitting device package according to an exemplary embodiment of the present invention;
FIG. 2 is a cross sectional view schematically showing the light emitting device package of FIG. 1; and
FIGS. 3A and 3B, FIGS. 4A and 4B, and FIGS. 5A and 5B show various examples of lenses and graphs schematically showing light distributions according to the various examples of the lenses, in the light emitting device package of FIG. 1.

## DETAILED DESCRIPTION OF THE PREFERRED EMBODIMENT

Exemplary embodiments of the present invention will now be described in detail with reference to the accompanying drawings. The invention may, however, be embodied in many different forms and should not be construed as being limited to the embodiments set forth herein. Rather, these embodiments are provided so that this disclosure will be thorough and complete, and will fully convey the scope of the invention to those skilled in the art. While those skilled in the art to which the invention pertains could readily devise many other varied embodiments that incorporate the teachings of the present invention through the addition, modification or deletion of elements, such embodiments may fall within the scope of the present invention.

In the drawings, the shapes and sizes of components are exaggerated for clarity. The same or equivalent elements are referred to by the same reference numerals throughout the specification.

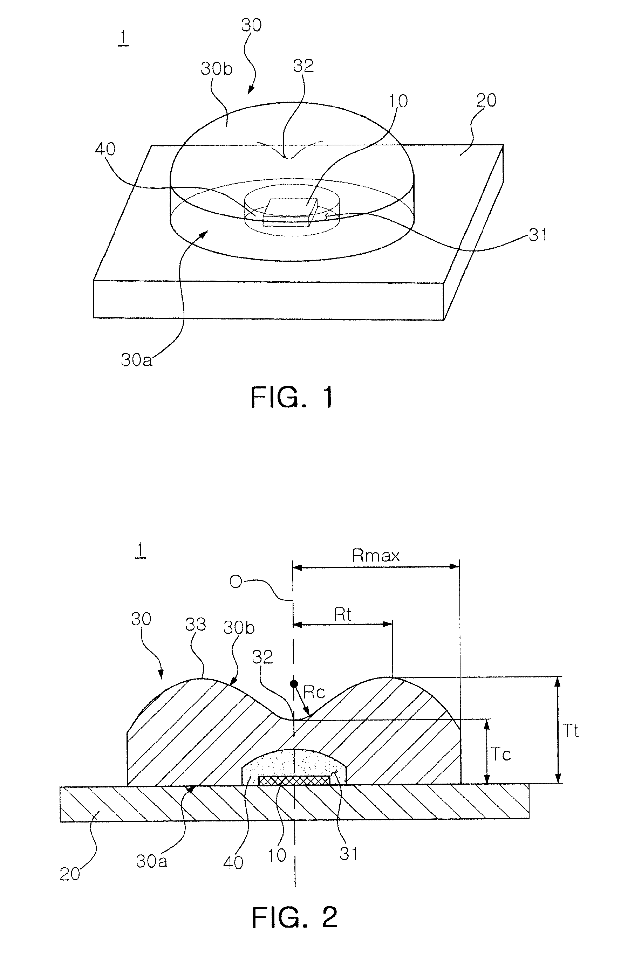

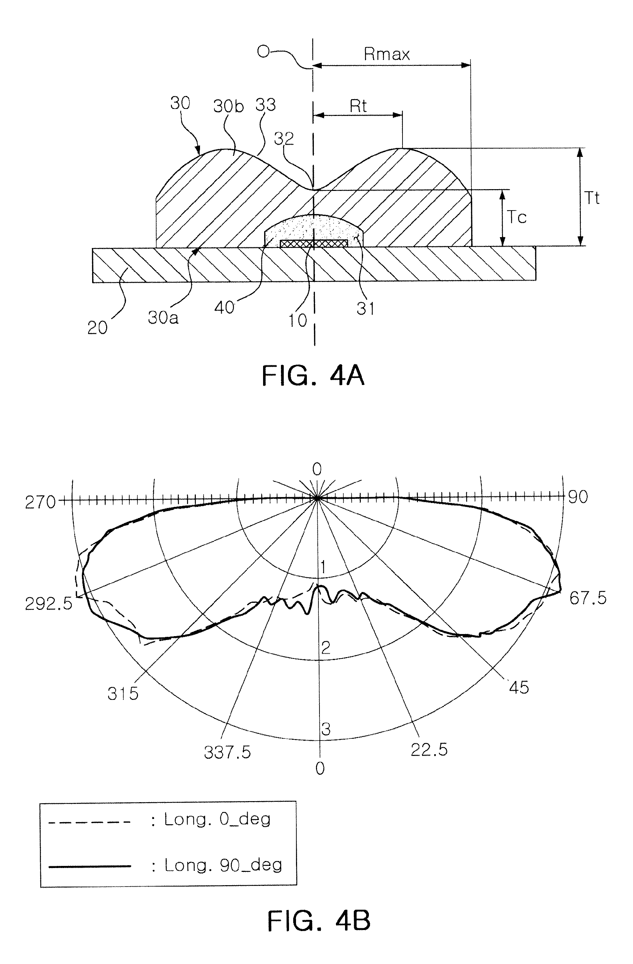

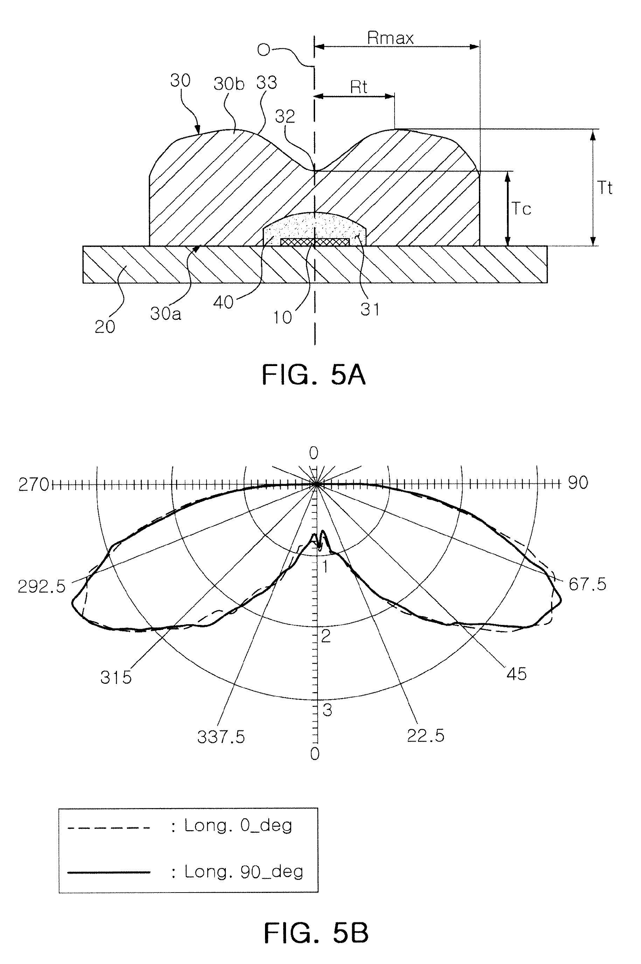

With reference to FIGS. 1 through 5, a light emitting device package according to an exemplary embodiment of the present will be explained.

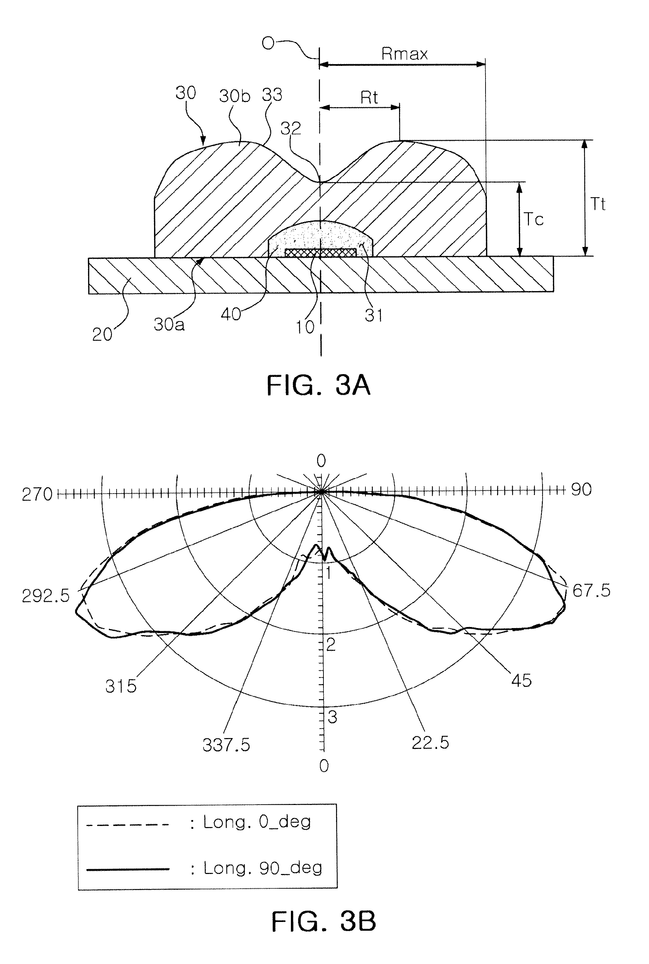

FIG. 1 is a diagram schematically showing a light emitting device package according to an exemplary embodiment of the present invention. FIG. 2 is a cross sectional view schematically showing the light emitting device package of FIG. 1. FIGS. 3A and 3B, FIGS. 4A and 4B, and FIGS. 5A and 5B show various examples of lenses and graphs schematically showing light distributions according to the various examples of the lens, in the light emitting device package of FIG. 1.

Referring to FIGS. 1 and 2, a light emitting device package 1 according to an exemplary embodiment of the present invention is configured to include a light emitting device 10, a substrate 20, and a lens 30.

The light emitting device 10, a kind of semiconductor device emitting light of a predetermined wavelength due to an electrical signal applied from the outside, may include an LED chip and may emit blue light, red light or green light according to a material contained therein, and the light emitting device 10 may also emit white light. The light emitting device 10 may be provided in plural, and the plurality of light emitting devices are mounted on the substrate 20 in such a manner as to be arranged thereon.

The substrate 20, a kind of printed circuit substrate (PCB), may be made of an organic resin material containing epoxy, triazine, silicon, polyimide or the like and the other organic resin materials and may be made of a ceramic material, such as aluminum nitride (AlN), aluminum oxide (Al$_2$O$_3$) or the like, a metal or a metal compound material. In particular, the substrate 20 may be a metal core printed circuit board (MCPCB), a kind of metal PCB, in an aspect of the radiation of heat.

The substrate 20 on which the light emitting device 10 is mounted may include a circuit wiring (not shown) electrically connected to the light emitting device 10, an insulating layer (not shown) having a withstanding voltage characteristic, or the like.

The lens 30 may be mounted on the substrate 20 so as to cover and seal the light emitting device 10. An accommodating groove 31 accommodating the light emitting device 10 may be formed in a lower surface 30A of the lens 30 contacting the substrate 20, and a concave portion 32 may be formed in an upper surface 30B of the lens 30 in such a manner as to be disposed at a position corresponding to the light emitting device 10. The lens 30 may be made of a transparent material, such as silicon, plastic, silica or the like. The accommodating groove 31 may be formed to have a size greater than that of the light emitting device 10, and a phosphor layer 40 filling the accommodating groove 31 and surrounding the light emitting device 10 may be provided between the inside of the accommodating groove 31 and the light emitting device 10. The phosphor layer 40 may contain at least one kind of fluorescent material therein, and convert the wavelength of light emitted from the light emitting device 10 into a wavelength having a desirable color, due to the fluorescent material. For example, the phosphor layer 40 may convert blue light into white light. In addition, the phosphor layer 40 may further contain a diffusion material therein, for a smooth diffusion of light.

The concave portion 32 formed in the center part of the upper surface 30B of the lens has a predetermined radius of curvature on an optical axis O of the lens 30, and may be formed to be depressed from the upper surface 30B to the lower surface 30A. In the case of the lens 30, the upper surface 30B may be formed to have a curved surface 33, the cross-section of which having parabolic shapes respectively based on the concave portion 32, and the curved surface 33 having the parabolic shapes may be formed at a location higher than that of the accommodating groove 32.

Through this structure, the light distribution of light emitted from the light emitting device 10 may be improved, to allow an orientation angle of light to be 130 degrees or more, whereby the number of the light emitting devices to be mounted may be reduced, allowing for the ensuring of cost competitiveness. In addition, a distance from the light emitting device 10 to an optical film (not shown) disposed above the light emitting device 10 may be reduced, whereby a product using the light emitting device package 1 may be slimmed.

Meanwhile, the lens 30 of the light emitting device package, according to an exemplary embodiment of the present invention, may be implemented within the scope of satisfying the above structural features and the following conditional expressions, in order to widen the light distribution of light emitted from the light emitting device 10 such that the required number of light emitting devices 10 may be reduced and at the same time, the thickness of a product using the light emitting device package may be reduced to thereby accomplish the slimming of the product.

Meanwhile, the lens 30 according to the exemplary embodiment of the present invention may be implemented within the scope satisfying the following conditional expression 1

[Conditional Expression 1]

$$0.4 < Tc/Tt < 0.85$$

Where Tc is a distance from the low surface of the lens to the upper surface thereof on the optical axis, and Tt is a distance from the lower surface of the lens to the upper surface thereof having the maximum height (hereinafter, referred to as 'the highest upper surface').

The conditional expression 1 is a condition for totally reflecting the luminous flux of light incident to the center part of the lens 30. When the implementation of the lens is beyond the upper limit of the conditional expression 1, the luminous flux of light incident to the center part of the lens 30 may be refracted without being totally reflected from the upper surface 30B including the curved surface 33 having the parabolic shapes, that is, a lens surface, whereby the luminous flux escaping from the lens 30 to the outside may be increased. Thus, the intensity of light in the vicinity of the optical axis 0 may be increased, whereby a hot spot, a brighter portion of a screen, as compared to the circumference thereof may tend to be generated. Further, when the implementation of the lens is beyond the lower limit of the conditional expression 1, the luminous flux of light incident to the center part of the lens 30 may be excessively refracted from the lens surface, whereby the intensity of light in the vicinity of the optical axis O may be sufficiently reduced to thereby cause the occurrence of speckles on the screen.

Meanwhile, the lens 30 according to the exemplary embodiment of the present invention may be implemented within the scope satisfying the following conditional expression 2, independently or together with the above conditional expression 1.

$$0.3 < Rt/Rmax < 0.75$$

Where Rt is a distance from the optical axis to the highest upper surface of the lens, and Rmax is a distance from the optical axis to an exterior surface of the lens.

The conditional expression 2 is a condition for controlling a degree to which the highest upper surface 30B, based on the lower surface 30A of the lens 30, is distant from the optical axis O. When the implementation of the lens is beyond the upper limit of the conditional expression 2, the luminous flux of light incident to the center part of the lens 30 may be refracted directly from the lens surface and advanced out of the lens 30, so that the intensity of light in the vicinity of the optical axis 0 may be increased, thereby allowing superior luminance to be exhibited around the location of the light emitting device 10 on a screen. However, a phenomenon in which luminance in an area of the lens distant from the light emitting device 10 is rapidly degraded may be generated on the screen. Further, when the implementation of the lens is beyond the lower limit of the conditional expression 2, the luminous flux of light incident to the circumferential part of the lens 30 may be refracted directly from the lens surface and advanced out of the lens 30, so that the intensity of light in the area distant from the optical lens O may be excessively increased, thereby causing a deterioration in luminance uniformity on the screen.

Meanwhile, the lens 30 according to the exemplary embodiment of the present invention may be implemented within the scope satisfying the following conditional expression 3, independently or together with at least one of the above conditional expressions 1 and 2.

[Conditional Expression 3]

$$0.1 < Rc$$

Where Rc is the radius of curvature of the concave portion formed in the upper surface of the lens, on the optical axis.

When the implementation of the lens is beyond the lower limit of the conditional expression 3, the function variation of the lens due to errors in the form of the lens 30 may be rapidly generated to have difficulties in stable quality assurance. In addition, in the case of molding the lens 30 by mold production, the unmolded portion of lens 30 may be generated.

Hereinafter, the lens 30 according to the exemplary embodiment of the present invention may be described through concrete numerical examples.

Example 1

According to Example 1, Tt is 1.27, Tc is 0.82, Rt is 0.85, Rmax is 1.77, and Rc is 0.15.

By applying the numerical values to the above conditional expressions, the values of the above conditional expressions are indicated as follows.
[Conditional Expression 1]: 0.65
[Conditional Expression 2]: 0.48
[Conditional Expression 3]: 0.15

Example 2

According to Example 2, Tt is 1.1, Tc is 0.68, Rt is 0.99, Rmax is 1.78, and Rc is 0.17.

By applying the numerical values to the above conditional expressions, the values of the above conditional expressions are indicated as follows.
[Conditional Expression 1]: 0.59
[Conditional Expression 2]: 0.56
[Conditional Expression 3]: 0.17

Example 3

According to Example 3, Tt is 1.33, Tc is 0.85, Rt is 0.82, Rmax is 1.64, and Rc is 0.16.

By applying the numerical values to the above conditional expressions, the values of the above conditional expressions are indicated as follows.

[Conditional Expression 1]: 0.64

[Conditional Expression 2]: 0.50

[Conditional Expression 3]: 0.16

The values according to the above Examples 1 to 3 may be test values within the range satisfying the conditional expressions 1 to 3. As in graphs shown in FIGS. 3A and 3B, FIGS. 4A and 4B, and FIGS. 5A and 5B, the luminous flux of light emitted in a direction of the optical axis O of the lens 30 is reduced, whereby the intensity of light expressed by luminous flux density per unit solid angle may be small, while the luminous flux of light emitted in a direction forming a large angle with respect to the optical axis 0 of the lens 30 is increased, whereby the intensity of light expressed by luminous flux density per unit solid angle may be greater.

Through the Examples of the present invention, light emitted from the center part of the lens 30 may be relatively small, while light emitted from the circumferential part of the lens 30 may be relatively great, whereby a light emitting device package in which the light distribution of light is increased may be configured.

As set forth above, according to exemplary embodiments of the invention, the light distribution of light emitted from the light emitting device may be greater to allow an orientation angle to be 130 degrees or more, whereby the number of the light emitting devices to be mounted may be reduced, allowing for the ensuring of cost competitiveness.

In addition, a distance from the light emitting device to an optical film may be reduced, whereby a product using the light emitting device package may be slimmed.

While the present invention has been shown and described in connection with the exemplary embodiments, it will be apparent to those skilled in the art that modifications and variations can be made without departing from the spirit and scope of the invention as defined by the appended claims.

**Claims**

1. A light emitting device package, comprising:

   a light emitting device;
   a substrate on which the light emitting device is mounted; and
   a lens mounted on the substrate so as to cover and seal the light emitting device and having an accommodating groove formed in a lower surface thereof contacting the substrate, the accommodating groove accommodating the light emitting device, and a concave portion formed in an upper surface thereof in such a manner as to be disposed at a position corresponding to the light emitting device,
   wherein the concave portion has a radius of curvature on an optical axis of the lens and is formed to be depressed from the upper surface to the lower surface.

2. The light emitting device package of claim 1, further comprising a phosphor layer filling the accommodating groove and surrounding the light emitting device.

3. The light emitting device package of claim 1, wherein in the lens, the upper surface is formed to have a curved surface, a cross-section of which having parabolic shapes respectively based on the concave portion, and the curved surface having the parabolic shapes is formed at a location higher than that of the accommodating groove

4. The light emitting device package of claim 1, wherein the lens satisfies the following conditional expression 1,

$$[\text{Conditional Expression 1}]$$

$$0.4 < Tc/Tt < 0.85$$

where, Tc is a distance from the lower surface of the lens to the upper surface thereof on the optical axis; and
Tt is a distance from the lower surface of the lens to the highest upper surface thereof.

**5.** The light emitting device package of claim 1, wherein the lens satisfies the following conditional expression 2,

$$[\text{Conditional Expression 2}]$$

$$0.3 < Rt/Rmax < 0.75$$

where, Rt is a distance from the optical axis to the highest upper surface of the lens; and
Rmax is a distance from the optical axis to an exterior surface of the lens.

**6.** The light emitting device package of claim 1, wherein the lens satisfies the following conditional expression 3,

$$[\text{Conditional Expression 3}]$$

$$0.1 < Rc$$

where, Rc is the radius of curvature of the concave portion formed in the upper surface of the lens, on the optical axis.

FIG. 1

FIG. 2

FIG. 3A

------- : Long. 0_deg

——— : Long. 90_deg

FIG. 3B

FIG. 4A

------ : Long. 0_deg

———— : Long. 90_deg

FIG. 4B

FIG. 5A

------- : Long. 0_deg

————— : Long. 90_deg

FIG. 5B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020110000985